# EUROPEAN PATENT APPLICATION

(11) **EP 4 815 638 A1**
(43) Date of publication of application: **30.09.2026**
(21) Application number: 25167013.9
(22) Date of filing: 28.03.2025
(51) Int. Cl.: H05K 1/02, H05K 1/18, H05K 3/46

(54) **COMPONENT CARRIER WITH POROUS BODY, AND MANUFACTURE METHOD**

(71) Applicant: AT & S Austria Technologie & Systemtechnik Aktiengesellschaft, 8700 Leoben-Hinterberg (AT)
(72) Inventor: OGGIONI, Stefano Sergio, 8700 Leoben (AT); KIRCHHEIMER, Karl Philipp, 8700 Leoben (AT)
(74) Representative: Dilg, Haeusler, Schindelmann Patentanwaltsgesellschaft mbH

(57) **Abstract**

There is described a component carrier (100) having a stack (101), comprising:
i) at least one electrically conductive layer structure (104),
ii) at least one electrically insulating layer structure (102), and
iii) at least one porous body (150) embedded in the stack (101),

wherein the porous body (150) has an external surface (151) configured to hinder a flow of material of the at least one electrically insulating layer structure (102) inside the porous body (150).

## Description

### Field of the Invention

The invention relates to a component carrier having a stack, comprising: at least one electrically conductive layer structure, at least one electrically insulating layer structure, and at least one porous body embedded in the stack, wherein the porous body has an external surface configured to hinder a flow of material of the at least one electrically insulating layer structure inside the porous body. The invention further relates to the component carrier, a porous body inlay, and a method of manufacturing.

Accordingly, the invention may relate to the technical field of component carriers, such as printed circuit boards or IC substrates, and their manufacture.

### Technical Background

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. At the same time, component carriers shall be mechanically robust and electrically and magnetically reliable so as to be operable even under harsh conditions.

In particular, providing a specific functionality, such as local thermal insulation, to a component carrier may still be considered a challenge. Conventionally, massive electrically insulating structures are applied for insulation in a component carrier. Yet, these structures require a lot of space and may be not be design-flexible for specific applications. Porous materials are known to have favorable thermal insulation properties. However, these materials are generally not applied in the context of component carriers. This is mainly due to the harsh conditions of component carrier manufacturing such as high temperature and pressure during lamination. During such a process, resin will flow into the pores of a porous material and thereby eliminating the porous properties. Further, porous materials are conventionally known to be delaminated in a component carrier stack easily. Some porous material (e.g., Si-aerogels) are hydrophilic, and if they absorb moisture, they usually suffer a structural change (even catastrophic break-down in many cases).

### Summary of the Invention

There may be a need to provide a functionality, in particular a thermal functionality, for a component carrier in an efficient and reliable manner. According to an exemplary embodiment of the invention, a component carrier, an inlay, and a method of manufacturing are described.

According to an aspect of the invention, there is described a component carrier (e.g. a printed circuit board, an IC substrate, an interposer, etc.) having a stack, comprising:
i) at least one electrically conductive layer structure (e.g. a patterned copper foil),
ii) at least one electrically insulating layer structure (e.g. a reinforced or non-reinforced resin), and
iii) at least one porous body (e.g. comprising polyimide) embedded (in particular encapsulated) in the stack,
wherein the porous body has an external surface (outer surface) configured to hinder (prevent, block) a flow of (resin) material of the at least one electrically insulating layer structure inside (into pores of) the porous body (in particular to hinder a flow of material to the inner pores of the core region of the porous body).

According to an aspect of the invention, there is described an inlay (component/ element, in particular manufactured separate from the stack), in particular a thermal management inlay, for a component carrier, the inlay comprising:
i) a porous body (in particular as described above);
ii) optionally at least one protection layer at least partially covering an external surface of the porous body,
wherein the external surface is configured (e.g. deformed, sealed/coated) to hinder a flow of a material of an electrically insulating layer structure (of a component carrier into which the inlay is placed/embedded) inside the porous body (e.g. using the protection layer).

According to an aspect of the invention, there is described a method of manufacturing a component carrier, the method comprising:
i) providing a stack comprising at least one electrically conductive layer structure and at least one electrically insulating layer structure; and
ii) embedding at least one porous body in the stack,
wherein the porous body has an external surface hindering a flow of material of the at least one electrically insulating layer structure inside the porous body.

In the context of the present document, the term "porous body" may particularly denote a component/element that comprises porous properties. For example, a porous body may comprise or consist of a material structure that contains interconnected or isolated pores (voids) within its volume. These pores can be filled with a fluid (gas or liquid), depending on the environment/application. The porosity of the material may significantly affect its mechanical, thermal, and electrical properties. For example, a porous material may function as a highly efficient thermal insulator. In an example, the following properties may be considered with respect to a porous body: porosity (the ratio of pore space to the total volume), pore structure (pores can be open (connected) or closed (isolated)), permeability (a measure of how easily fluids pass through the interconnected pores), and material composition (e.g. inorganic or organic). In an embodiment, the porous body may comprise a polymer, for example polyimide. In an embodiment, the porous body can have a plurality of shapes, for example plate-shaped. In a further embodiment, the porous body may be compressible and/or flexible. Still in another example, the pores may be located inside the porous body and/or on the surface of the porous body.

In the context of the present document, the term "external surface" may particularly denote an outermost profile/boundary of the porous body that is exposed to the surrounding environment. The external surface may be seen as an interface between the porous body material and external factors such as gas, liquids, or other substances. For example, if the porous body has a plate-shape, the external surface may be defined by the two opposed main surfaces and eventually also by the surface of the lateral wall between said main surfaces. In an embodiment, the external surface may have at least one different pore-related property as an inner region (e.g. the core region), in particular as the whole other part, of the porous body. Based on said at least one different pore-related property, the external surface may hinder a flow of material inside the porous body (to the inner region). Pores at the external surface may be considered as external pores, while pores at the inner/core region may be considered as inner pores.

In the context of the present document, the term "hinder a flow of material" may particularly denote a property of the external surface of the porous body to block/prevent/preclude flow of material, such as resin, into the (inner) porous body. In an embodiment, the external surface may have a different porosity as the inside/rest of the porous body. For example, the pores at the external surface may be partially or fully closed, thereby hindering material flow to the inside of the porous body. Such a different porosity may be achieved by different means. For example, a protection layer may be at least partially provided onto the external surface of the porous body, so that the material of the protection layer at least partially flows into the pores of the external surface only. In another example, the external surface may be thermally, chemically or mechanically treated, so that such a specific deformation prevents the material flow to the inside of the porous body. This may be achieved by closing at least one external pore and/or shrinking the pore diameter of the external pore in comparison to the pore diameter of an internal pore.

In the context of the present document, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board (PCB), an organic or inorganic interposer, and an integrated circuit (IC) substrate. A component carrier may also be a hybrid board combining different ones of the above-mentioned types of component carriers.

In the context of the present document, the term "stack" may particularly denote (a structure that is manufactured preferably in) a flat or planar sheet-like body (but that can be even folded/shaped into three dimensional shape at a later stage) (this in a particular example, due to the specific properties of the porous material in being flexible by nature and compatible with thermal treatments/processes even after embedding into the specific construction/matrix). For instance, the stack may be a layer stack, in particular a laminated or rolled layer stack. Such a laminate may be formed by connecting a plurality of layer structures by the application of mechanical pressure and/or heat. Preferably, the plurality of layer structures are aligned parallel on top of each other. The stack may comprise electrically conductive layer structures and at least one electrically insulating layer structure.

In the context of the present document, the term "layer structure" may particularly denote a continuous layer, a patterned layer or a plurality of nonconsecutive islands (discontinuous) within a common plane, and it may perform the function of electrical conductivity and/or electrical insulation and/or thermal conductivity and/or thermal insulation. A layer structure may also comprise an interconnection structure which protrudes from a planar surface of the layer structure.

According to an exemplary embodiment, the invention may be based on the idea that a thermal (insulation) functionality for a component carrier can be provided in an efficient and reliable manner, when a porous body is embedded in a component carrier stack, whereby the porous body external surface is configured to hinder a flow of insulating material (e.g. prepreg resin) of the stack inside the porous body. Especially, during a manufacturing step, when an electrically insulating material is at least partially flowable, the external surface of the porous body may hinder the flow of the electrically insulating material to enter/flow inside the porous body.

Conventionally, thermal insulation in a component carrier is provided by massive structures of thermally insulating material. Porous materials are known to be highly thermally insulating; however, they are generally not considered for embedding in a component carrier. This is because, during the lamination process (that applies high pressure and/or heat), the pores of a porous material will be filled by flowing resin from the surrounding insulating layers of the stack. Thereby, the porous functionality (and the favorable thermal properties) will be lost. Further, porous materials are conventionally known to be delaminated in a component carrier stack easily. Some porous material (e.g., Si-aerogels) are hydrophilic, and if they absorb moisture, they usually suffer a structural change (even catastrophic break-down in many cases).

It has now been found by the inventors that these drawbacks may be solved in a straightforward and surprisingly efficient manner: the external surface of the porous body is configured to hinder such a flow of material into the porous body. This effect may be achieved by one or more (e.g. in combination) measures. In a first embodiment, the external surface may be covered/coated by a protection layer. Hereby, the protection layer may protect the external surface from external material flow. In an example, material of the protection layer may partially flow into the pores of the external surface, thereby sealing the external surface. In a second embodiment, the external surface may be configured to be (essentially) porous-free, thereby preventing any material flow inside the porous body. In a third embodiment, the external surface may be deformed (e.g. thermally or chemically), thereby sealing the external surface against material flow.

In summary, only the external (exposed) surface of the porous body is affected by the measures described (e.g. sealing, coating, deforming). All of the inner regions of the porous body may not be involved in such a process and keep their porous network matrix. Thus, the main part or core region of the porous body may not be affected by the preparation of the external surface and the thermal insulation properties remain. Thus, the described porous body can be efficient and robust against (material flow in the) component carrier manufacture processes.

In an exemplary embodiment, the thermal conductivity of the porous body (e.g. polyimide) is 0.034 W/m*K (at 25° C), while the one for copper is 398 W/m*K, demonstrating the high thermal insulation capacity.

Additionally or alternatively, the porous body may be used for antenna applications; since the porous body can be filled with gas, this may have a beneficial effect in regard to losses of radio frequency signals. Additionally or alternatively, the porous body has an external surface (outer surface) configured to hinder (prevent, block) entering material of the at least one electrically conductive layer structure inside (into pores of) the porous body (in particular to hinder entering of material to the inner pores of the core region of the porous body).

In an embodiment, the porous body may provide a large variety of three-dimensional shapes, based on the specific properties of the porous material in being flexible by nature and compatible with thermal treatments/processes even after embedding into the specific construction/matrix.

### Exemplary Embodiments

In an embodiment, the external surface is (essentially or fully) porous free. This may provide the advantage that a flow of material inside the porous body is (essentially) completely blocked. A porous/pore free external surface may hinder any material to flow into the inner pores of the porous body. There may be different means to realize a porous free external surface. For example, a material of a protection layer or a deformation process may be applied onto the external surface such that (essentially) no open pores remain at the surface of the external surface. In an embodiment, at least one main surface of the porous body is porous free. In a further embodiment, a lateral wall (between two main surfaces of the porous body) is porous free or not porous free. In the first case, the porous body may be efficiently sealed. In the second case, efforts may be saved, since only the external regions (main surfaces) are sealed.

In an embodiment, the external surface has a porosity different, in particular smaller, from the average porosity of the (inner/core region or the) entire porous body. This may provide the advantage that the property of hindering a material flow can be realized in a straightforward and well-controllable manner, e.g. by closing a part or all of the external surface pores. In an embodiment, the hindering of the flow of material inside the porous body is at least partially obtained by this different/smaller porosity at the external surface of the porous body.

In an embodiment, the porosity at the external surface is smaller than the porosity at a core region of the porous body. This may provide the advantage that the inner region or core region (in particular the whole porous body but the external surface) of the porous body may be well protected against material flow and comprises a high porosity. A high porosity may provide advantageous functions such as a high thermal insulation property to the component carrier. In an embodiment, at least a portion of the external surface of the porous body has a porosity different from the porosity of the core region of the porous body. In this example, it is not required that the whole external surface comprises a different porosity as the inner/core region, but only a part. For example, only one or two main surfaces may comprise a different porosity as the inner region, while a lateral wall (with a smaller surface than the main surfaces) comprises a similar porosity as the inner region. In this manner (focusing on the relevant external part of the porous body), costs and efforts may be saved.

In an embodiment, the external surface of the porous body is deformed (comprises a deformation, a deformed structure), thereby affecting the porosity at the external surface. This may provide the advantage that the hindering property of the external surface can be obtained by a straight-forward deformation process. Such a process may be efficient, reliable and/or well controllable. In the following, examples of such a deformation process are described.

In an embodiment, the deformation comprises a mechanical deformation. This may provide the advantage that the deformation may be obtained in a straightforward manner with established technology. In an embodiment, a mechanical deformation may generate a dimple and/or an indentation at/in the external surface. In an embodiment, the deformation may be the result of a pressing step. For example, a pressing step may be applied to deform the external surface such that a plurality of pores are narrowed/constricted and/or closed.

In an embodiment, the deformation comprises a thermal deformation. This may provide the advantage of an easy process, for example a heating/cooling. In an embodiment, the thermal deformation may generate a wavy interface/surface portion and/or a portion comprising mixed/intermingled material. In an embodiment, the deformation may be the result of a melting step. For example, a part of the external surface may (partially) melt, thereby narrowing/closing some or all of the external surface pores.

In an embodiment, the deformation comprises a chemical deformation. This may provide the advantage that the deformation may be adjusted in a desired manner, e.g. for specific applications. In an embodiment, the deformation may generate a portion comprising different roughness and/or an oxidized surface/interface. In an embodiment, the deformation may be the result of an etching step. For example, a suitable etchant/acid may be used to alter the external surface, e.g. to roughen the surface or to destroy network structures, thereby closing pores at the external surface. In a further example, oxidation means may be applied to oxidize (a part of) the external surface. Since oxidation adds material (enlarges the surface), the pores at the external surface may be narrowed or even closed.

In an embodiment, the external surface of the porous body comprises a protection material, in particular at least one protection layer. Such a protection layer may be arranged at the external surface, thereby (partially) coating/sealing the external surface. The hindering of the flow of undesired material inside the porous body may be at least partially obtained by the protection material of the protection layer. In this manner, the protection layer may protect the external surface and the inner region of the porous body from material flow. In an embodiment, the protection layer may be placed on a main surface of the porous body. In a further embodiment, a further protection layer may be placed on a further (opposed) main surface of the porous body. In a further embodiment, a protection layer is placed on at least one lateral wall of the porous body. In yet another embodiment, at least one (in particular all) lateral/side walls are free of the protection layer.

In an embodiment, the protection material at least partially, in particular entirely, closes the pores at (at least a part of) the external surface of the porous body. In an embodiment, the protection layer may be in direct physical contact with the external surface, thereby protecting the external surface. While in a first embodiment, material of the protection layer enters into pores of the external surface, in a second embodiment, the pores of the external surface are (essentially) free of protection layer material.

In an embodiment, the protection material is at least partially immersed inside the porous material at the external surface. This may provide the advantage that the external surface is efficiently sealed, while the inner region of the porous body is not affected by the protection material.

In an embodiment, the protection material comprises at least one external surface feature (for example a specific surface tension, a specific contact angle, a functionalization) hindering the flowing of material inside the porous body. This may provide the advantage that the protection layer may be configured to provide (additionally to the structure of the external surface) a hindering effect to the external surface. The protection layer may be processed (in a separate process) to yield such surface features. In another example, the material of the protection layer may be selected to already comprise such surface features.

In an embodiment, the protection material is at least partially arranged at/on the external surface of the porous body. For example, the protection layer may be laid/rolled/laminated on the external surface of the porous body. In an embodiment, the protection material is configured as a foil (in particular at least a single foil). Such a foil may be applied in a straightforward manner to the external surface using established techniques. A foil may be especially design-flexible to fit a large variety of applications. In an embodiment, at least a single foil is used. In another embodiment, multiple foils can be used, for example in a pre-manufactured stack of porous material and glue layers.

In an embodiment, the protection material comprises a resin, in particular epoxy resin. This may provide the advantage that established component carrier material can be directly applied, e.g. within the same manufacture facility. Since the component carrier normally also comprises resin (such as epoxy resin), these materials may well coexist, e.g. regarding coefficient of thermal expansion. In an embodiment, the resin may be free of fillers. In another embodiment, the resin may comprise fillers such as fibers or particles (spheres). In an exemplary embodiment, the protection material partially enters inside the porous body (partially) closing the external pores, in particular the fillers do not enter the pores.

In an embodiment, the protection layer material comprises fillers on purpose to facilitate the flow of (a small amount of) resin material in the pores of the external surface (thereby sealing the external surface). For example, the resin matrix around the fillers may partially flow into the pores, while the fillers do not (too large to enter the pores). Thereby, only a limited amount of protection layer material (the resin matrix but not the fillers) is enabled to enter the external pores of the porous body.

In an embodiment, the porous body comprises two opposed main surfaces connected one to each other by at least one lateral surface/sidewall. In an embodiment, the external surface (configured to hinder a flow of material of the at least one electrically insulating layer structure inside the porous body) is provided at one, in particular both, of the two opposed main surfaces. In an embodiment, the different porosity of the external surface, in particular being different from the porosity of the inner/core region, is provided at one or at both main surfaces. In a further embodiment, the porosity of the upper external surface and the lower/bottom external surface is similar or different one to each other. This may provide the advantage that only the relevant region of the porous body is protected against material flow, thereby saving costs and efforts. In an embodiment, the porous body may comprise a plate-shape and is embedded in the component carrier. A resin material flow during the lamination process can occur generally from above and below (in particular during a pressing process). Hindering the material flow at one or each main surface may thus be highly efficient against material flow inside the porous body.

In an embodiment, the external surface is different at one main surface or both of the main surfaces compared to at least one lateral surface (e.g. regarding porosity). As described above, costs/efforts may be saved, when the lateral surface is not treated or less treated than the main surface(s). For example, a deformation process may affect the lateral surface less than the main surface(s). In a further example, protection layers may only be applied to the main surface(s). In an embodiment, the (untreated) external surface at the lateral surface has essentially similar properties as the inner region of the porous body.

In an embodiment, (a part or) the whole external surface of the porous body is configured to hinder a flow of material of the at least one electrically insulating layer structure inside the porous body. In an embodiment, (a part or) the whole external surface of the porous body has a porosity different from the porosity of the inner/core region. This may provide the advantage of an efficiently and reliably sealed porous body. In an embodiment, all surfaces of the porous body may be configured to hinder material flow inside. For example, a deformation process (in particular thermal or chemical) may affect the whole external surface in the same manner.

In an embodiment, the porous material of the porous body is organic. In an embodiment, the porous material of the porous body comprises a fibrous material. In an embodiment, the porous material of the porous body comprises an (Si-, silica-) aerogel. In an embodiment, the porous material of the porous body comprises a flexible material. In an embodiment, the porous material comprises a network matrix. In an embodiment, the porous material is sponge-like. In an embodiment, the porous material of the porous body comprises a compressible material. In an embodiment, the porous material of the porous body comprises or consists of polyimide. Depending on the desired application, one or more of these examples may be especially advantageous. For example, polyimide is widely used in the component carrier manufacture as a flexible material. However, using polyimide to provide a flexible porous body may be considered an especially advantageous embodiment. Preferably, the porous material of the porous body may be different than the material of the protection material.

According to an exemplary embodiment, the porous body is made of polyimide (layers) using e.g. a sol-gel process; the outcome is a dense network of crosslinked branches with a very high ratio of empty spaces. This thermosetting material may be in a fully C-stage and polyimide is a polymer containing imide groups belonging to the class of high-performance plastics. With their high heat-resistance, polyimides enjoy diverse applications in roles demanding rugged organic materials, such as applications with high temperature thanks to their thermo-stability. Once the surfaces are sealed, then the foil can be processed as expected in the lamination press cycle. In an embodiment, the porous material (foil) is flexible and can be "conformal" to the positioning of flat as well as structured surfaces.

In an exemplary embodiment, silica aerogels are known for their thermal insulating properties. Despite the name, aerogels are solid, rigid materials that do not resemble a gel in their physical properties. These are also "fragile" in their behaviors when exposed to mechanical stresses with the tendency of shattering like glass (a property known as friability). Moreover, silica aerogels have specific properties as well as some critical aspects. Owing to its hygroscopic nature, aerogel feels dry and acts as a strong desiccant. Si-Aerogels by themselves are hydrophilic, and if they absorb moisture they usually suffer a structural change (often catastrophic break-down) to the point of dissolving if immersed into water. Silica aerogels are rigid and prone to break when undergoing bending. These materials may not survive the pressing cycles and the other (wet) conditions present into a component carrier manufacturing process flow. However, in an embodiment, using the concept of the external surface that hinders material flow to the inside, an aerogel-like flexible material (as defined above) may be used to provide an efficient porous body.

In an embodiment, the component carrier further comprises a heat source, wherein the porous body is associated, in particular functionally associated, with the heat source. This may provide the advantage that the porous body may provide a highly efficient thermal insulation property (heat shield, thermal cut) for such a heat source, e.g. a processor, a power application, an optical device, etc. In an embodiment, the porous body may be provided in a highly design-flexible manner into a large variety of heat-producing applications.

In an embodiment, the heat source is embedded in the stack. In an embodiment, the heat source is arranged on the stack (surface-mounted) or is connected to the stack. In an embodiment, the porous body is arranged between the heat source and one main surface of the stack. In this manner, the porous body may be embedded in the stack in a flexible manner (flexible design options but also potentially flexible material) to efficiently meet the respective needs. Additionally or alternatively, the heat source may provide a further function to the stack.

In an embodiment, the heat source comprises a component, in particular at least one of a power component, a processor (like a CPU, GPU, NPU, ASIC), an optical fiber, a waveguide, a photonic transceiver, a laser device. This may provide the advantage that a large variety of different heat-producing devices may be efficiently and reliably thermally insulated using the porous body. For example, the porous body may be placed in direct contact to a heat source, thereby efficiently protecting other (heat sensitive) parts of the component carrier and/or avoid overheating such as an integrated (surface) mirror in MOEMS and MEMS application, a sensor, or other thermally sensitive device.

In an embodiment, the porous body is associated with an electrically conductive structure, in particular at least one of: the heat source, a layer structure, a trace, a pad, a terminal, a patterned metal layer structure, a vertical connection, a via, a horizontal structure, a vertical structure, a (through) thermal conductive structure, a thermal conductive structure at least partially extending through the porous body. Besides the above described component, a plurality of other component carrier parts produce heat, e.g. thermal/electric vertical connections, high current traces/vias, etc. The porous body may be placed such that also these structures may be efficiently and reliably thermally insulated. In a specific embodiment, the structure to be insulated extends through the porous body.

In an embodiment, the conductive structure extends only through the porous body. In another embodiment, the conductive structure extends through the porous body and (part of) the stack. In an advantageous manner, thermal conduction of porous body and stack may be combined in a thermal connection structure that extends through porous body and stack.

In a specific embodiment, a (through) connection is formed in the porous body to remove a fluid, in particular a gas and/or moisture. This may provide the advantage of increased thermal insulation properties. In particular empty (moisture free) pores may provide a higher insulation.

In an embodiment, the component carrier and/or the porous body further comprises a filling material inside the (through) thermal conductive structure and/or the vertical connection. Thereby, specific properties may be obtained. For example, the connection may be made thermally/electrically conductive and/or thermally/electrically insulating.

In an embodiment, the filing material is at least one of: thermally conductive, electrically conductive, magnetic. Depending on the application, specific properties may be provided, e.g. electric conduction and/or improved inductance (e.g. supporting an inductive coil by magnetic material).

In an embodiment, a thermal-electrical interconnection or a magnetic material is arranged inside the filling material, in particular so that the filling material forms a shield around. Such a structure may be obtained for example by filling an opening, re-opening (partially) the filled opening, and refilling the (filled) opening. In this manner, a specific functionality (e.g. electrically conductive, magnetic, etc.) may be protected by insulating material and/or further electrically conductive material (e.g. plated sidewalls).

In an embodiment, the porous body is arranged between the heat source and a further element. In an embodiment, an electrical connection is provided between the heat source and the further element. In an embodiment, the electrical connection passes through the porous body. Thereby, a (heat producing) electric connection may be efficiently insulated, avoiding over-heating and/or disturbance of neighboring components.

In an embodiment, the porous body comprises a filled opening. In an embodiment, the porous body comprises a further opening (in particular by re-opening the filled opening). In an embodiment, the further opening is at least partially filled with another filling material (and formed in the filled opening). Thereby, many applications may be realized, in particular in connection with applications of the stack.

In an embodiment, the porous body comprises a multilayer structure (in particular stacked layers). This may enable a flexible and efficient manufacturing process. For example, depending on the required size, two or more layers (e.g. of polyimide) may be stacked to meet said size requirement. In another example, different layers may be combined, thereby pronouncing different (thermally insulating) properties. In a further example, a stabilization layer may be introduced between porous layers. In an embodiment, the external surface (hindering the material flow inside) may be provided for the whole porous body or for each layer of the multilayer stack individually.

In an embodiment, the porous body is provided in a cavity in at least one of the layer structures of the stack. This may enable an efficient and robust embedding/encapsulation process with established component carrier techniques.

In an embodiment, the component carrier further comprises: an embedding/encapsulant material (e.g. resin). In an embodiment, the porous body is embedded/encapsulated by the encapsulant material in the cavity. In an embodiment, the encapsulant material flowed between the porous body and the cavity wall and/or the encapsulant material originates from the at least one electrically insulating layer structure. Embedding in a stack is a well-known and established technique in component carrier manufacture. Yet, due to the specific external surface, the porous body may be efficiently embedded, while keeping its highly advantageous porous properties. In other words, there is (essentially) no flow of the encapsulant material inside the porous body but only around the external surface of the porous body, enabling robust encapsulation.

In an embodiment, the porous body comprises a fluid, in particular gas (e.g. air), in the empty space (void) of the porous material. In an embodiment, the empty space of the porous material is (essentially) moisture-free. A gas such as air in the pores may increase the thermal insulation properties; for example, air has a very low thermal conductivity of 0.025 W/m*K. Yet, moisture or a liquid in the pores may decrease the thermal insulation properties; for example, water has a higher thermal conductivity of 0.6 W/m*K. In an embodiment, moisture may be removed from the inside of the porous body by forming an opening in the porous body. Said opening may be later-on filled (see above).

In an embodiment, the porous body is provided in the stack as part of an inlay. In an embodiment, the inlay comprises the porous body and at least one protection layer. In the present context, the term "inlay" may in particular refer to a component/element/device that is (essentially) independent of the component carrier stack and placed/arranged in the stack during component carrier manufacture. In a preferred embodiment, the inlay is produced in a separate process and not in the stack manufacture process (e.g. lamination, plating, etc.). This may provide the advantage that the inlay may be produced depending on the required needs and eventually without high temperature/pressure conditions. For example, the external surface may be configured for hindering material flow to the inside during the inlay manufacture process. If such a step would be performed during component carrier manufacture, the pores of the inside may be undesirably filled with resin. In an example, the inlay manufacture may comprise a deformation step and/or providing a protection layer to the external surface (see above).

In an embodiment, the porous body is sandwiched between two protection layers. In an embodiment, the inlay further comprises: a further protection layer, wherein the porous body is sandwiched between the protection layer and the further protection layer. Thereby, the opposed main surfaces of the porous body may be well protected against material flow (in particular from above and below during pressing). In an embodiment, e.g. when the protection layer comprises resin, at least part of the protection layer may flow over a lateral surface of the porous body, thereby also protecting the external surface at the lateral side. In an embodiment, the protection layers are embedded in the stack. In an embodiment, only one protection layer is embedded in the stack. Hence, the whole inlay (with protection layers) may be efficiently embedded in the stack.

In an embodiment, the method further comprises providing the porous body as an inlay into a cavity of the stack. As described above, the porous body may be (part of) an independent and flexibly usable component that can be placed where needed.

In an embodiment, the method further comprises coating the external surface with a protection layer and/or changing the external surface by a deformation. As described above, these measures may enable an adjustment of the external surface to hinder efficiently material flow to the inside.

In an embodiment, the inlay comprises the porous body and at least one protection layer at least partially covering an external surface of the porous body. In an embodiment, the inlay comprises a further protection layer, wherein the porous body is sandwiched between the protection layer and the further protection layer.

In an embodiment, the method further comprises forming an opening in the porous body, in particular before embedding in the stack. Such an opening may enable the removal of undesired fluid (gas, liquid, moisture) from the inner region of the porous body, thereby increasing the thermal insulation properties. Further, such an opening may be filled with material, thereby providing specific properties/functionalities.

In an embodiment, the method further comprises filling the opening in the porous body to provide a filled opening, in particular filling with stack material (e.g. conductive or insulating material). This may provide the advantage of a robust coexistence of materials, e.g. comparable/similar coefficient of thermal expansion. Depending on the desired application, different functionalities can be realized by the filling material.

In an embodiment, the method further comprises (partially) re-opening the filled opening, in particular when forming an opening in the stack. This may provide the advantage that a (vertical) connection structure in the porous body can be interconnected with a (vertical) connection structure in the stack. Further, different functionalities can be combined, for example, a (plated) through-hole (in particular through porous body and stack) may be provided.

In an embodiment, the method further comprises re-filling the re-opened (filled) opening. In an embodiment, the method further comprises filling with an electrically conductive material and/or plating a sidewall of the opening with the electrically conductive material. The re-filling may provide for example a specific functionality, e.g. electrically/thermally conductive/insulating, magnetic, etc. If previously filled material remains, said previously filled material may serve as a protection/shield for the re-filled material.

In an embodiment, the method further comprises pressing the porous body, in particular when embedded in the stack. Such a pressing would normally fill the pores of the porous body in an undesired manner with stack material. However, using the specific external surface, the material flow is hindered from reaching the inner pores of the porous body. Accordingly, lamination/pressing can be done including the porous body, enabling an efficient and reliable stack formation process. In an embodiment, the pressing may reduce the size of the porous body, in particular if the porous body is compressible and/or flexible, for example when using polyimide. Thereby, the size of the porous body may be adjusted to the desired size in the stack without pressing material into the inner pores.

In an embodiment, the porous body (and/or the inlay with the porous body) is at least partially manufactured in a controlled gas atmosphere, using for example (an inert gas) such as nitrogen, argon, neon, or other combination of gases. Such an inert atmosphere may improve the manufacturing conditions, for example by preventing oxidation, impurities, or undesired chemical reactions.

According to an exemplary embodiment, the use of a flexible sponge-like material made of a base of polyimide resin, helps in reducing the heat transfer into selected areas of the component carrier. These areas can then host temperature sensitive elements (like optical benches, optics, temp sensitive components with aligned optical waveguides, fibers, etc.)

According to an exemplary embodiment, polyimide-insulating foils (porous body) are laminated or inserted into cavities, along with layer(s) of resin sheets or adhesive films (of the stack). Using optical devices, one may need adhesives to join optical components, in particular avoiding adhesives that may have alignment problems over the thermal operating range or over the lifetime of the device. Keeping the overall functional temperature low (using the porous body as a thermal insulator), may extend the service life of the parts and the aforementioned and may improve the performance of the optical systems.

According to an exemplary embodiment, thermally insulating layer(s) (pororus body) made of a flexible thermally insulating material are sued for the creation of "thermally shielded" areas in electronic substrates which are bearing components sensitive to thermal excursions. Creation of differential thermal substrate sections (thermal partitioning of the substrate configuration) may be enabled.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). A printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier, in particular an IC substrate. An IC substrate may be, in relation to a PCB, a comparably small component carrier onto which one or more components may be mounted and that may act as a connection medium between one or more chip(s) and a further PCB. For instance, an IC substrate may have substantially the same size as a component (in particular an electronic component) to be mounted thereon (for instance in case of a Chip Scale Package (CSP)). More specifically, an IC substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections may in particular be arranged within the IC substrate and may be used to provide electrical, thermal and/or mechanical connections of housed components or unhoused components (such as bare dies), particularly of IC chips, with a printed circuit board or intermediate printed circuit board.

A "substrate" in the context of the present application in particular facilitates electrical connections and/or dissipating heat and/or offering mechanical strength. Thus, the term "substrate" is in particular used as a synonym of "IC substrate" in the context of the present application. It has to be noted that the term "substrate" may in particular not been mixed up with the term "substrate" as it is usually used in the wafer context in which "substrate" usually means the substrate material used in wafer manufacturing as a base material upon which devices or circuits are built and which forms the foundational layer that supports the electronic or photonic structures integrated into a wafer. This is not what is meant with "substrate" in the context of the present application.

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, Melamine derivates, Polybenzoxabenzole (PBO), bismaleimide-triazine resin, polyphenylene derivate (e.g. based on polyphenylenether, PPE), polyimide (PI), polyamide (PA), liquid crystal polymer (LCP), polytetrafluoroethylene (PTFE), Bisbenzocyclobutene (BCB) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, titanium, molybdenum and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one component (in particular the embedded component), which may be surface mounted on and/or embedded in the component carrier, can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor or reflective connection), an electronic component, or combinations thereof. An inlay can be for instance a metal block, with or without an insulating material coating (IMS-inlay), which could be surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a micro-optoelectromechanical systems (MOEMS), a capacitor, a resistor, an inductance, a battery, a switch, a camera, an antenna, a logic chip, and an energy harvesting unit. However, other components may be surface mounted on the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further component carrier, for example in a board-in-board configuration. The component may be surface mounted on the component carrier. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of an component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

The aspects defined above and further aspects of the invention are apparent from the examples of embodiment to be described hereinafter and are explained with reference to these examples of embodiment.

### Brief Description of the Drawings

Figure 1 illustrates a component carrier, according to an exemplary embodiment of the invention.
Figure 2A, Figure 2B, and Figure 2C respectively show a porous body inlay, according to exemplary embodiments of the invention.
Figure 3A shows a microscopic image of the external main surface of the porous body, Figure 3B shows a microscopic image of the external lateral surface, and Figure 3C shows a microscopic image of the inner region of the porous body, according to exemplary embodiments of the invention.
Figures 4A and Figure 4B respectively show a cross-section through a component carrier stack with the embedded porous body, according to exemplary embodiments of the invention.
Figure 5A and Figure 5B show a comparison of a heating test of a component carrier with the porous body, according to an exemplary embodiment of the invention, and a conventional circuit board.
Figure 6 shows a top view on the porous body inlay with thermal conductive structures, according to an exemplary embodiment of the invention.
Figure 7A, Figure 7B, Figure 7C, Figure 7D, Figure 7E, and Figure 7F respectively show microscopic images of the porous body, according to exemplary embodiments of the invention.
Figure 8A, Figure 8B, Figure 8C, Figure 8D, Figure 8E, Figure 8F, Figure 8G, Figure 8H, Figure 8I, Figure 8J, and Figure 8K show a manufacture process of a component carrier with a porous element, according to exemplary embodiments of the invention.
Figure 9, Figure 10, and Figure 11 respectively illustrate a component carrier with an embedded porous body, according to exemplary embodiments of the invention.

### Detailed Description of the Drawings

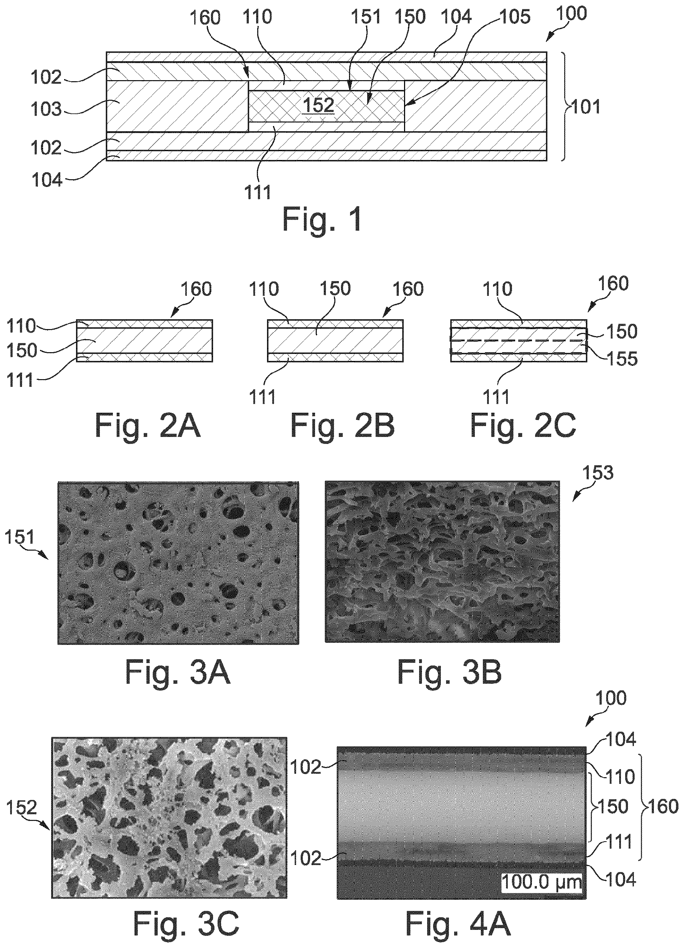

**Figure 1** illustrates a component carrier 100, according to an exemplary embodiment of the invention. The component carrier 100 has a stack 101, comprising a core layer structure 103 sandwiched between two electrically insulating layer structures 102, further sandwiched between two electrically conductive layer structures 104. A porous body 150 is provided in a cavity 105 in an electrically insulating layer structure, in particular the core layer structure 103. The porous body 150 is embedded in the core layer structure 103 of the stack 101, wherein the porous body 150 is part of an inlay 160. Said inlay 160 has been manufactured independent of the component carrier stack 101 and has been placed in a cavity in the core layer structure 103 in a previous step. The porous body inlay 160 comprises said porous body 150, in particular the inlay 160 comprises the porous body 150 and at least one protection layer 110. Additionally, the porous body 150 is sandwiched between an (upper) protection layer 110 and a (lower) further protection layer 111. In this example, the upper/lower main surface of the inlay 160 is/are flush with the upper/lower main surface of the core layer structure 103. Alternatively, a main surface of the porous body may be in direct contact with the core layer structure (not shown).

The porous body 150 has an external surface 151, in particular two external surfaces 151, configured to hinder a flow of material of the electrically insulating layer structures 102 (of the stack 101) inside the porous body 150. The different porosity of the external surfaces 151, in particular being different from the porosity of the core region 152, is provided at one, in particular both opposed, main surfaces of the porous body 150. The porosity of the external surface 151 and the porosity of the core region 152 can be seen in Figure 3A and Figure 3C. Still referring to Figure 1, the electrically insulating layer structures 102 are provided in this example in an uncured (not fully cured) state and therefore partially flow. For example, these layer structures 102 comprise a resin, such as prepreg or ABF foils, which is cured over time (e.g. fully cured in a final component carrier product) and/or during manufacturing, for example hot-press lamination, baking. During the manufacture process, the electrically insulating layer structure 102 material is partially flowable and may thus flow into the pores of the embedded porous body 150 (material penetration). In order to avoid this undesired effect, the external surface 151 of the porous body 150 prevents such a flow to the inside (inner pores) of the porous body 150.

In the example of Figure 1, hindering the flow of material into the porous body 150 is achieved by the protection layer 110 and the further protection layer 111, which have been assembled to the porous body 150 in a previous step, i.e. before embedding the porous body inlay 160 into the stack 101 of the component carrier 100. As discussed above in detail, the protection layer 110 and the further protection layer 111 function as a barrier that partially or fully closes the pores at the external surface 151 of the porous body 150 only (compare Figures 3A to 3C), thereby protecting (sealing) the inner pores of the porous body 150.

In particular, the protection layer structure 110 fully covers one main surface of the porous body 150. Additionally or alternatively, the further protection layer structure 111 fully covers the opposed other main surface of the porous body 150. Preferably, the whole external surface 151 of the porous body 150 is configured to hinder a flow of material of the at least one electrically insulating layer structure 102 inside the porous body 150, in particular the whole external surface 151 of the porous body 150 has a porosity different from the porosity of the core region 152. The sidewall of the porous body 150 is in direct contact with the core layer structure 103. The porous body 150 is in direct contact with the core layer structure 103, the protection layer structure 110, and the further protection layer structure 111. Additionally or alternatively, the protection layers 110, 111 are embedded in the stack 101. In an example, at least one protection layer 110, 111 is a distinct layer structure. Additionally or alternatively, the electrically insulating layer structure 102 may comprise at least one protection layer structure 110, 111. In particular, the electrically insulating layer structure may comprise material forming a protection layer structure during a manufacturing process, especially without the need of providing a distinct protection layer structure.

**Figure 2A, Figure 2B, and Figure 2C** respectively show a porous body inlay 160, according to exemplary embodiments of the invention.

Figure 2A: the upper and lower main surface of the porous body 150 are respectively covered by (sandwiched between) a protection layer 110 and a further protection layer 111. The protection layers 110, 111 are relatively thick in comparison to the thickness of the porous body 150.

Figure 2B: very similar to Figure 2A, yet the protection layers 110, 111 are relatively thin in comparison to the thickness of the porous body 150.

Figure 2C: in this example, the porous body 150 is a multi-layer structure that comprises two stacked layers: a first porous body layer 150 and a second porous body layer 155. These layers 150, 155 can have similar or different properties, in particular regarding porosity. The first porous body layer 150 and the second porous body layer 155 are connected with each other, in particular without further material in between. This may be achieved since the main surface of the first porous body layer 150 and the main surface of the second porous body layer 155 get caught on the respective main surface of the other porous body layer due to the porous/rough surface. Additionally or alternatively, the first porous body layer 150 and the second porous body layer 155 are connected with each other, in particular with an adhesive in between. In a further example, more than two porous body layers (e.g. three or four) can be stacked.

**Figure 3A** shows a microscopic image of the external main surface 151 of the porous body 150, **Figure 3B** shows the external lateral surface 153, **and** **Figure 3C** shows a microscopic image of the inner core region 152 of the porous body 150, according to exemplary embodiments of the invention. The material of the porous body 150 may be a porous material. Additionally or alternatively, the material of the porous body 150 as shown in Figure 3A to Figure 3C is organic, in particular the material of the porous body 150 comprises polyimide. In an example, the material of the porous body 150 may comprise flexible material and/or may comprise flexible properties. In another example, the material of the porous body 150 may comprise compressible material and/or may comprise compressible properties.

Figure 3A: it can be seen (in particular in comparison with Figures 3B and 3C) that a plurality of pores at the external surface 151 have been closed or made narrower/smaller. This effect can for example be achieved by a protection layer (e.g. a resin) that covers the external surface. Material of the protection layer may hereby partially flow in a part of the pores at the external surface 151, thereby sealing/coating the external surface 151. The external surface 151 has therefore a porosity different, in particular smaller, from the average porosity of the entire porous body. In other words, the surface topography allows sealing with high viscosity resin material.

The external surface of the porous body may comprise a protection material, in particular the protection layer (not shown). The protection material at least partially may close the pores at the external surface of the porous body. Further additionally or alternatively, the protection material may be at least partially arranged at the external surface of the porous body. In particular, at least a portion of the external surface may be free of pores/porous free. The porosity at the external surface may be affected, due to the fact that the external surface of the porous body is deformed. In an example the deformation may comprise a mechanical deformation and/or a thermal deformation and/or a chemical deformation. In a specific embodiment (not shown), an intermingling (region) between the material of the external surface and the material of the protection layer may be present.

Figure 3B: shows an image of the external lateral surface 153 of the porous body 150. While Figure 3C (see below) shows the core region 152, Figure 3B shows a lateral surface of the porous body 150. It can be seen that the external surface 151 is different at one main surface (see Figure 3A) compared to the lateral surface 153 shown in Figure 3B. In this example, the pores at the external main surface 151 are smaller/narrower than the pores at the external lateral surface 153.

Figure 3C: shows an image of the inside (core region) 152 of the porous body 150. In comparison to the external main surface 151 of Figure 3A, the inner pores (in other words: inner hollow spaces of the porous body network matrix) are open in the core region 152 and enable a high thermal insulation performance. These inner pores can be filled with a gas such as air; yet, moisture in the pores should be avoided. In other words, the porous body 150 and/or the inlay 160 may comprise a fluid, for example gas, in the empty space of the porous material and/or the empty space of the porous material (inside the porous body and/or the inlay 160) may be essentially moisture-free. When comparing Figure 3A with Figure 3C, it can be seen, that the porosity at the external main surface 151 is smaller than the porosity at a core region 152 of the porous body 150. Additionally or alternatively, at least a portion of the external surface 151 of the porous body 150 has a porosity different from the porosity of the core region 152 of the porous body 150.

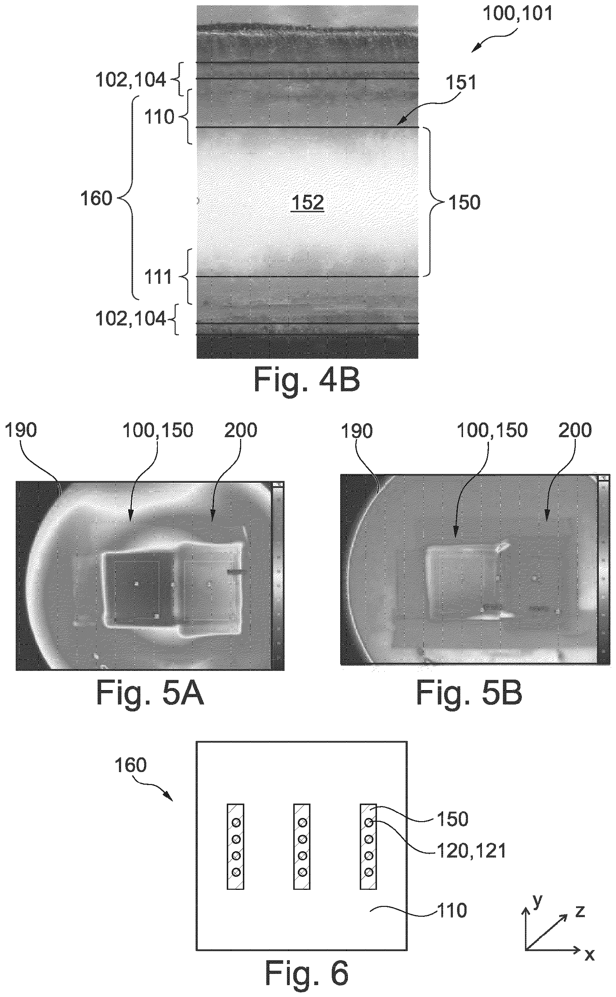

**Figure 4A** **and** **Figure 4B** respectively show an image of a cross-section through a component carrier 100 stack with the embedded porous body 150, according to exemplary embodiments of the invention.

Figure 4A: the porous body 150 is covered above and below by a respective protection layer 110, 111, wherein the protection layer 110, 111 material is in direct physical contact with the external surface 151 of the porous body 150. The protected porous body 150 is further covered above and below by respective electrically insulating layer structures 102 and electrically conductive layer structures 104. The protection layers 110, 111 in direct contact with the external surface 151 hinder material of the electrically insulating layer structures 102 to flow into the pores of the porous body 150. During the manufacture process of the component carrier 100, the stack has been pressed (e.g. during a lamination process). Hereby, the thickness of the porous body 150 has been reduced in comparison to its original size, thereby fitting in the present stack architecture. In the example shown, the thickness (z) of the porous body 150 is around 100 µm.

Figure 4B: shows a more detailed image of the cross-section. In this view, it can be seen that material of the protection layers 110, 111 (e.g. provided by lamination and not fully cured; flowable; e.g. epoxy resin) partially enters the pores at the external surface 151 of the porous body 150 (penetration depth). Nevertheless, the pores at the inside (core region 152) of the porous body 150 remain free of the material of the protection layers 110, 111. Thus, the protection layers 110, 111 may serve as a sealing/coating for the external surface 151. The external surface 151 of the porous body comprises protection material, in particular at least one protection layer 110, 111. It is indicated in this Figure, that the porous body 150, together with the protection layers 110, 111, forms an inlay 160. Such an inlay 160 can be further covered by layer structures 102, 104, e.g. by lamination and/or plating of the stack 101. Additionally, material of the protection layer 110 is at least partially penetrating into the porous body 150 and/or material of the further protection layer 111 is at least partially penetrating into the porous body 150.

**Figure 5A and Figure 5B** show a heating test of a component carrier 100 comprising the porous body 150 (left side) and a conventional circuit board 200 without the porous body (right side). The respective sample is placed onto a hot plate 190, which is then heated from room temperature (Figure 5A) to around 65⁰C (Figure 5B) in five minutes (to simulate a heat source). It can be seen that the right sample 200 is heated much faster and stronger than the component carrier 100 according to the invention. In this heating test, a temperature difference of around 10⁰C has been measured, thereby demonstrating the high thermal insulating performance of the described porous body 150.

Described in other words, lab testing was performed to evaluate the effect of the use of the porous body 150 in a substrate 100. Parts were placed onto a hotplate 190 and exercised with heat; the results of empirical measurements with a thermo-camera showed a reduction of heat transfer on the surface of the areas where the thermo-insulating material (porous body 150) was implemented being cooler that other standard construction 200 by at least 10 °C. The temperature of the component carrier 100 is not only lower compared to the conventional circuit board 200, but also to the surroundings. Moreover, the use of this material can be complemented within the substrate design with a "thermal cut" in all metal layers involved in a potential heat transfer from heating elements toward temperature sensitive components.

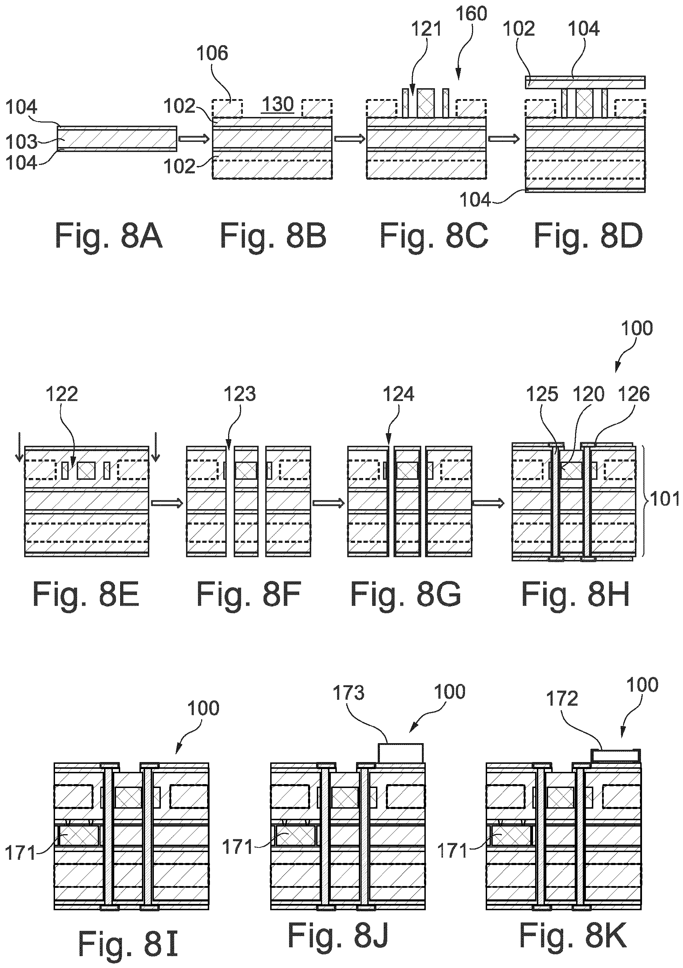

**Figure 6** shows a top view on the porous body inlay 160 with openings 121 to form thermal conductive structures 120, according to an exemplary embodiment of the invention. In this example, the inlay 160 comprises the porous body 150, the protection layer 110 and vertical through connections 120. In particular, the porous body 150 is covered by a protection layer 110, so that the external main surface belongs to said protection layer 110. At three slot regions, the protection layer 110 has been opened to expose (the external surface of) the porous body 150. Openings 121 have been formed by drilling in (and eventually through) the porous body 150. In further steps (see for example Figure 8), these openings 121 can be filled by electrically insulating material and/or electrically conductive material to provide e.g. a (through) thermal conductive structures 120. When embedding the inlay 160 in a component carrier 100, the openings 121 can be filled together with openings of the component carrier 100 with encapsulant material 102. Additionally or alternatively, filled openings can be (partially) re-opened and eventually be filled again with electrically conductive material.

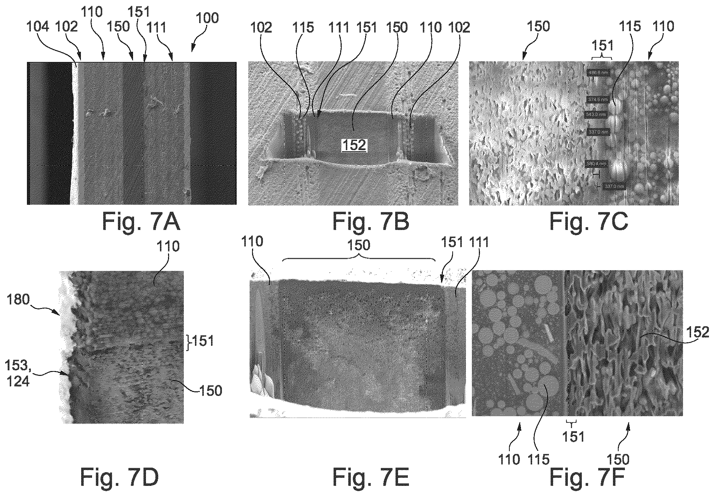

**Figures 7A to Figure 7F** respectively show high magnification (Focus Ion Beam) images of the porous body 150 in the porous body inlay 160 and/or in the component carrier 100, according to exemplary embodiments of the invention.

Figure 7A: the porous body 150 is sandwiched between the protection layer 110 and the further protection layer 111 (e.g. epoxy resin). The protection layers 110, 111 are relatively thick in comparison to the porous body 150 in this example. The protection layers 110, 111 protect the opposed main surfaces of the porous body 150 against (resin) material flow from component carrier stack material. It can be seen in the image that material of the protection layers 110, 111 partially entered into outer pores of the external surface 151, thereby partially closing the external surface 151. Yet, it can be further seen that the protection layer material 110, 111 only entered into the external surface 151 of the porous body 150 and not into the inner/core region of the porous body 150.

The porous body 150, preferably along with the protection layers 110, 111 which sandwich the porous body 150,forms an inlay 160 placed between electrically insulating layer structures 102 and electrically conductive layer structures 104 of the stack 101. Preferably, the electrically conductive layer structure 104 is exposed to the environment. It can be seen in Figure 7A, that the porous body 150 is protected by the protection layers 110, 111 and that no material of the electrically insulating layer structures 102 and/or material of the electrically conductive layer structure 104 can flow to the inside of the porous body 150.

Figure 7B: shows an image of the outer main surface (side of a sectioned substrate of) the component carrier 100. A cavity has been formed by the use of FIB in the stack 101 (turned by 90⁰), so that the inner structure can be seen. The porous body 150 is arranged between the protection layers 110, 111 (compare Figure 7A). This inlay is further sandwiched between the electrically insulating layer structures 102 with glass fillers 115. It can be seen that material of the electrically insulating layer structures 102 is hindered (by the protection layers 110, 111) from entering the inside 152 of the porous body 150.

Figure 7C: shows an interface region between the porous body 150 (on the left side) and the protection layer 110 (on the right side). The porous body 150 comprises a plurality of open pores and the protection layer 110 comprises a plurality of filler particles 115 (e.g. a reinforce material). The external surface 151 forms the interface, where material of the protection layer 110 partially enters and closes some of the pores at the external surface 151. It can be further seen that the protection layer 110 material does not enter deeper as the external surface 151. Further, no filler particles 115 enter into the pores of the porous body 150. In this example, the thickness of the external surface 151 region can be in the range 337 nm to 580 nm.

Figure 7D: shows another interface between the porous body 150 and the protection layer 110. On top of both structures, a metallic layer 180 has been deposited. Additionally, the shown Figure 7D demonstrates a plated sidewall 124. The electrically conductive material, in particular metallic layer 180, partially enters and closes some pores at the external surface 151, in particular an opening in the porous body 150. The electrically conductive material may be applied by chemical vapor deposition and/or physical vapor deposition.

Figure 7E: shows a thick porous body 150 between thin protection layers 110, 111. In this example, there is nearly no material of the protection layers 110, 111 in the pores of the external surface 151.

Figure 7F: shows a further interface between the porous body 150 and the protection layer 110. In this example, there is a clear demarcation between the porous body 150 and the protection layer 110: essentially no protection layer 110 material has entered the pores of the external surface 151. In this example, filler particles 115 in the protection layer 110 (resin) material can be clearly seen.

**Figures 8A to Figure 8K** show a manufacture process of a component carrier 100 with a porous element 150, according to exemplary embodiments of the invention.

Figure 8A: there is provided a core layer 103 (fully cured resin, e.g. FR4) covered at the upper and lower main surface respectively with an electrically conductive layer structure 104. The electrically conductive layer structure 104 covers the entire main surface of the core layer 103. Optionally the electrically conductive layer structure 104 may be structured and at least a portion of the main surface of the core layer 103 may be exposed (not shown).

Figure 8B: the electrically conductive layer structures 104 are respectively covered (laminated) by electrically insulating layer structures 102, in this example a base prepreg. Said layers 102 are then further respectively covered (laminated) by electrically insulating layer structures 102 (also prepreg). Lamination can be done by tackling only, i.e. no soft lamination or full curing. In the upper electrically insulating layer structure 102, there is formed a cavity 130 which is delimited by the electrically insulating material 106 around the cavity. Optionally, the electrically insulating layer structure 102 sandwiched between the exposed electrically insulating layer structure and the electrically conductive layer structure 104 can be omitted. Instead of providing two stacked electrically insulating layer structures 102, only one electrically insulating layer structure comprising a blind cavity may be applied (not shown).

Figure 8C: the above described inlay 160 is placed into the cavity 130. The inlay 160 comprises a porous body 150 with an external surface 151 that hinders flow of material to the inside of the porous body 150 (see Figure 2A to Figure 2C). The inlay 160 can eventually comprise protection layers 110, 111. Further, openings 121 have been formed (in a previous step) through the porous body 150. The openings 121 extend from one main surface, in particular one external surface 151, of the porous body 150 and/or the inlay 160 to the second (opposed) main surface 151, of the porous body 150 and/or the inlay 160. One main surface of the inlay 160 is protruding out of the exposed main surface of the electrically insulating layer structure 102, 106. In other words, the inlay 160 has a bigger thickness compared to the exposed electrically insulating layer structure 102. Since the prepreg 102 is not fully cured (and may behave as an adhesive), the inlay 160 can be adhered at the bottom of the cavity 130.

Figure 8D: a further electrically insulating layer structure 102 (e.g. prepreg), covered by a further electrically conductive layer structure 104 (e.g. copper foil) is arranged on top of the inlay 160. In the first place, the inlay 160 is larger (in the thickness direction z) than the electrically insulating material 106 around the cavity. Hence, the further electrically insulating layer structure 102 is not in contact with the electrically insulating material 106 around the cavity.

Figure 8E: the component carrier preform is pressed (see arrows for illustration) together. In an example, the manufacturing process pressing may include an application of elevated temperatures, for example higher than 70°C, and/or elevated pressure, for example larger than 1.5 bar. Thereby, the further electrically insulating layer structure 102 and/or the electrically insulating material 106 gets at least partially flowable and the further electrically insulating layer structure 102 gets in contact with the electrically insulating material 106 around the cavity. Further, material of the further electrically insulating layer structure 102 and/or the electrically insulating material 106 fills the space of the cavity 130 around the inlay 160. Thereby, the further electrically insulating layer structure and the electrically insulating material may intermingle with each other.

Also, the electrically insulating layer structure 102 and/or the further electrically insulating layer structure 102 fills the openings 121 in the porous body 150, thereby forming (resin) filled openings 122 in the porous body 150. The surface of the openings 121 are in direct contact with the electrically insulating layer structure 102 and/or the further electrically insulating layer structure 102, in particular the exposed pores of the porous body 150/the inlay 160 located at the openings 121 are covered with the electrically insulating layer structure 102 and/or the further electrically insulating layer structure 102. This is possible, since the material of the (further) electrically insulating layer structure(s) 102 is not fully cured and (partially) flowable. Nevertheless, said flowing material does not enter the porous body 150, in particular the internal porous body 152, since the external surface 151 is configured to hinder such an effect.

Figure 8F: vertical through-holes are formed from the upper main surface to the lower main surface of the component carrier preform. The vertical through-holes may be formed by a mechanical drill process step and/or a laser drilling process step. Thereby, the filled openings 122 in the porous body 150 are re-opened to generate re-opened openings 123. Yet, some of the electrically insulating filling material 122 can remain at the sidewalls of the re-opened openings 123. The re-opened openings 123 comprise a smaller lateral extension, for example a diameter, smaller than the lateral extension of the openings 121.

Figure 8G: a plating step is performed to fill the sidewalls of the vertical through holes, in particular the re-opened openings 123 (here with remaining insulating material 122), to obtain plated through-holes (with plated sidewalls 124). The plating step provides metal, for example copper, at the sidewall of the re-opened openings 123. The plating step may comprise a electroless metal deposition process, for example e-less plating and/or chemical or physical vapor deposition.

Figure 8H: a plugging step is performed to (completely) fill the plated through-holes 124 with a plugging past (filling material 125) (e.g. an electrically insulating/conductive material), thereby obtaining a thermal connection structure 120 (vertical through connection). Additionally or alternatively, the plated trough-holes 124 may be filled with magnetic paste and/or the through-hole 124 may be fully filled with metal, for example copper. Then, these re-filled openings 120 are capped 126 (e.g. with an electric connection material), eventually after a grinding step. Further, the external electrically conductive layer structures 104 are covered by a surface layer, e.g. a surface finish.

The inlay 160 is located in a non-central layer of the stack 101 in regard to thickness direction. The porous body 150 comprises a filled opening 121, 122, and wherein a further opening 123, in particular at least partially filled with another filling material 124, 125. Thereby, a final component carrier 100 with a stack 101 can be provided.

Figure 8I shows an embodiment of the final component carrier 100 with an embedded component 171 in the central core layer 103. In this specific example, the embedded component 171 is an embedded die that is electrically connected (at the top main surface) to the electrically conductive layer structure 104 on top of the core layer 103.

Figure 8J shows an embodiment of the final component carrier 100 with the embedded component 171 and a surface-mounted component 173, in this specific example a CPO (Co-packaged optics) sensor. The embodiment of Figure 8K is very similar to the one of Figure 8J, yet, a capacitor 172 is applied as the surface-mounted component.

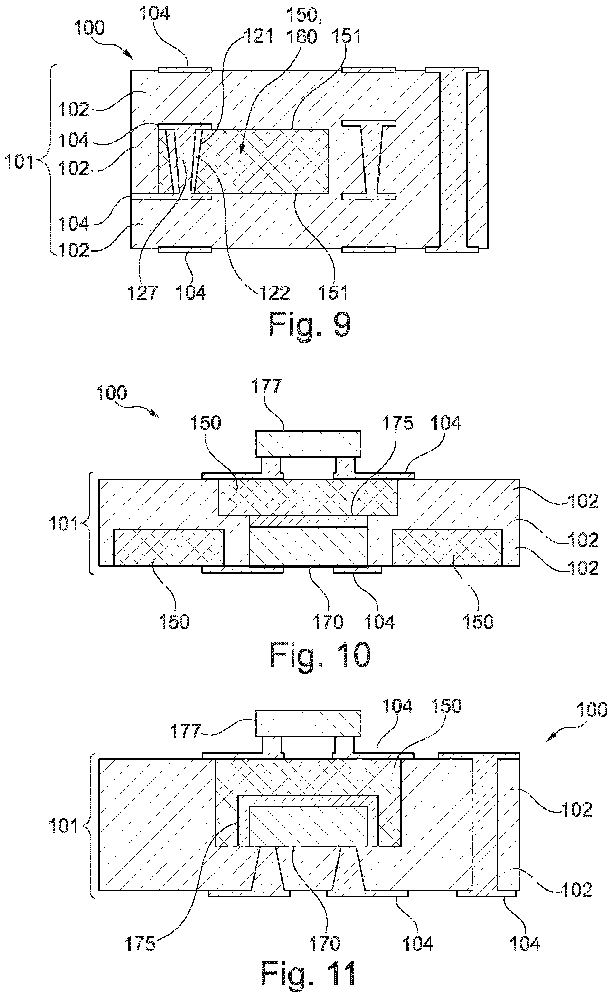

**Figure 9** shows a cross-sectional view of a further component carrier 100 as an exemplary embodiment of the present invention. In the present example, the component carrier 100 comprises a stack 101 comprising three stacked electrically insulating layer structures 102 and four electrically conductive layer structures 104. The porous body 150 is embedded as an inlay 160 in one electrically insulating layer structure 102, in particular the central electrically insulating layer structure 102 in regard to thickness direction. The porous body 150 comprises an opening 121 passing from one external surface of the porous body 151 to the second opposed external surface of the porous body 151. The opening 121 is filled with electrically insulating material originated from at least one of the electrically insulating layer structures 102.

Additionally, the opening 121 is filled with electrically conductive material, in particular copper, thereby creating a metal filled through connection 127. The opening 121 is further filled with material such, that the sidewall of the opening 121 is in direct contact with the electrically insulating material 122. Said electrically insulating material 122 is laterally sandwiched between the electrically conductive material of the filled through connection 127 and the porous body 150. This may create a co-axial connection between the two opposed main surfaces of the porous body 151. The metal filled through connection 127 has a tapered shape (e.g. a result from laser drilling through the porous body 150). Additionally or alternatively, the metal filled through connection 127 is mechanically and/or electrically connecting two electrically conductive layer structures 104 of the stack 101.

A further similar metal filled through connection is connecting the same two electrically conductive layer structures 104 without passing through the porous body 150. Additionally, a fully metal filled through connection is mechanically and/or electrically connecting the two exposed electrically conductive layer structures 104.

**Figure 10** shows a cross-sectional view of a further component carrier 100 as an exemplary embodiment of the present invention. In the present example, the component carrier 100 comprises a stack 101 comprising a plurality of electrically insulating layer structures 102 and two electrically conductive layer structures 104. Additionally, the stack 101 comprises a heat source 170 embedded in the stack 101. The heat source 170 may be a power component. Additionally, the stack 101 comprises three porous bodies 150 embedded in the stack 101. Two porous bodies 150 are provided such in the stack 101, that they are located laterally next to the heat source 170 (side-by-side). A further porous body 150 is located above the heat source 170 in regard to thickness direction.

The heat source 170 is associated, in particular functionally associated, to the further porous body 150. The further porous body 150 has a lateral extension being different, in particular larger, than the lateral extension of the heat source 170 (having a larger lateral extension). An adhesive material 175 is provided between the heat source 170 and the further porous body 150. Preferably the adhesive material 175 may be thermally insulating. The adhesive material 175 is in direct contact with one main surface (the upper main surface) of the heat source 170 and one main surface of the porous body 150 (the lower main surface). Electrically insulating material, in particular material form one of the plurality of electrically insulating layer structures 102, is laterally provided, in particular in direct contact to, the heat source 170 and/or the at least one porous body 150 and/or the adhesive material 175.

The electrically conductive layer structures 104 are provided at the exposed surfaces of the stack 101. One of these electrically conductive layer structures 104 is in direct contact with the porous body 150 and the heat source 170. Additionally or alternatively, another electrically conductive layer structure 104 is in direct contact with the heat source 170 and free from direct contact with one of the porous bodies 150. Preferably, the electrically conductive layer structure 104 may be electrically connected to the heat source 170.

Additionally, a further component 177 is surface mounted on the stack 101. The further component 177 may be a sensor. The further component 177 is electrically connected to one of the electrically conductive layer structures 104. The further porous body 150 is arranged between the heat source 170 and the further component 177 and/or between the heat source 170 and the main surface of the stack 101. This may bring the advantage of thermally protecting the sensor 177 from the heat generated by the heat source 170. Preferably, an electrical connection is further provided between the heat source 170 and the further component 177.

**Figure 11** shows a cross-sectional view of a further component carrier 100 as an exemplary embodiment of the present invention. In comparison to Figure 10, the heat source 170 is at least partially located inside the porous body 150. In particular, the porous body 150 comprises a shape like the letter "U". The sidewalls of the heat source 170 are encompassed by the porous body 150. Additionally or alternatively, the heat source 170 is connected to the porous body 150 such, that the adhesive material 175 is laterally provided between the heat source 170 and the porous body 150 and/or the adhesive material 175 is provided between one main surface of the heat source 170 and a main surface of the porous body 150. The electrically conductive layer structure 104 is connect by a metal filled vertical through connection with the heat source 170. Additionally or alternatively, the porous body 150 is associated with an electrically conductive structure 104, for example the heat source 170 and/or an (electrically conductive) layer structure.

### Reference signs

- 100: Component carrier
- 101: Stack
- 102: Electrically insulating layer structure, encapsulation material
- 103: Core layer structure
- 104: Electrically conductive layer structure
- 105: Cavity
- 106: Electrically insulating material around cavity
- 110: Protection layer
- 111: Further protection layer
- 115: Glass fillers
- 120: Thermal conductive structure, vertical through connection
- 121: Opening in porous body
- 122: Filled opening in porous body
- 123: Re-opened opening in porous body
- 124: Plated sidewall
- 125: Filling material
- 126: Electric connection, plug
- 127: Metal-filled through connection
- 130: Cavity
- 150: Porous body
- 151: External (main) surface porous body
- 152: Internal porous body, core region
- 153: External lateral surface porous body
- 155: Further porous body layer
- 160: Inlay
- 170: Heat source
- 171: Embedded die
- 172: Capacitor
- 173: Sensor
- 175: Adhesive material
- 177: Further component
- 180: Metal layer
- 190: Heating device
- 200: Conventional circuit board

## Claims

1. A component carrier (100) having a stack (101), comprising:
at least one electrically conductive layer structure (104),
at least one electrically insulating layer structure (102), and
at least one porous body (150) embedded in the stack (101),
wherein the porous body (150) has an external surface (151) configured to hinder a flow of material of the at least one electrically insulating layer structure (102) inside the porous body (150).

2. The component carrier (100) according to claim 1,
wherein the external surface (151) is porous free.

3. The component carrier (100) according to claim 1 or 2,
wherein the external surface (151) has a porosity different, in particular smaller, from the average porosity of the entire porous body (150).

4. The component carrier (100) according to one of the preceding claims,
wherein the porosity at the external surface (151) is smaller than the porosity at a core region (152) of the porous body (150); and/or
wherein at least a portion of the external surface (151) of the porous body (150) has a porosity different from the porosity of the core region (152) of the porous body (150).

5. The component carrier (100) according to one of the preceding claims,
wherein the external surface (151) of the porous body (150) is deformed, thereby affecting the porosity at the external surface (151),
in particular deformed by at least one of:
a mechanical deformation, in particular a dimple and/or an indentation;
a thermal deformation, in particular a wavy interface/surface portion and/or a portion comprising mixed/intermingled material;
a chemical deformation, in particular a portion comprising different roughness and/or an oxidized surface/interface.

6. The component carrier (100) according to one of the preceding claims,
wherein the external surface (151) of the porous body (150) comprises a protection material, in particular at least one protection layer (110, 111), in particular
wherein the protection material at least partially, in particular entirely, closes the pores at the external surface (151) of the porous body (150); and/or
wherein the protection material is at least partially immersed inside the porous material at the external surface (151); and/or
wherein the protection material is at least partially arranged at/on the external surface (151) of the porous body (150); and/or
wherein the protection material is configured as a foil; and/or
wherein the protection material comprises a resin, in particular epoxy resin.

7. The component carrier (100) according to one of the preceding claims,
wherein the porous body (150) comprises two opposed main surfaces connected one to each other by at least one lateral surface, and
wherein the external surface (151) configured to hinder a flow of material of the at least one electrically insulating layer structure (102) inside the porous body (150) being provided at one, in particular both, of the two opposed main surfaces,
in particular the different porosity of the external surface (151), in particular being different from the porosity of the core region (152), is provided at one or at both main surfaces.

8. The component carrier (100) according to one of the preceding claims, wherein the porous material of the porous body (150) is organic; and/or wherein the porous material of the porous body (150) comprises a fibrous material;
wherein the porous material of the porous body (150) comprises an aerogel; and/or
wherein the porous material of the porous body (150) comprises a flexible material; and/or
wherein the porous material of the porous body (150) comprises a compressible material; and/or
wherein the porous material of the porous body (150) comprises polyimide.

9. The component carrier (100) according to one of the preceding claims, further comprising:
a heat source (170), wherein the porous body (150) is associated, in particular functionally associated, with the heat source (170),
in particular
wherein the heat source (170) is embedded in the stack (101); and/or
wherein the heat source (170) is arranged on the stack (101) or is connected to the stack (101); and/or
wherein the porous body (150) is arranged between the heat source (170) and one main surface of the stack (101); and/or
wherein the heat source (170) is a component, in particular at least one of a power component, an optical fiber, a waveguide, a laser device.

10. The component carrier (100) according to one of the preceding claims,
wherein the porous body (150) is associated with an electrically conductive structure, in particular at least one of:
the heat source (170);
a layer structure;
a vertical connection, in particular a via;
a horizontal structure,
a thermal conductive structure (120) at least partially extending through the porous body (150),
in particular further comprising:
a filling material (125) inside the thermal conductive structure (120) or the vertical connection,
in particular
wherein the filing material is at least one of: thermally conductive, electrically conductive, magnetic; and/or
wherein a thermal-electrical interconnection or a magnetic material is arranged inside the filling material, in particular so that the filling material forms a shield around.

11. The component carrier (100) according to one of the preceding claims,
wherein the porous body (150) comprises a fluid, in particular gas, in the empty space of the porous material; and/or
wherein the empty space of the porous material is essentially moisture-free.

12. The component carrier (100) according to one of the preceding claims,
wherein the porous body (150) is sandwiched between two protection layers (110, 111),
in particular wherein said protection layers (110, 111) are embedded in the stack (101).

13. An inlay (160), in particular a thermal management inlay, for a component carrier (100), the inlay (160) comprising:
a porous body (150); and
a protection layer (110) at least partially covering an external surface (151) of the porous body (150),
so that the external surface (151) is configured to hinder a flow of a material of an electrically insulating layer structure (102) inside the porous body (150),
in particular further comprising:
a further protection layer (111),
wherein the porous body (150) is sandwiched between the protection layer (110) and the further protection layer (111).

14. A method of manufacturing a component carrier (100), the method comprising:
providing a stack (101) comprising at least one electrically conductive layer structure (104) and at least one electrically insulating layer structure (102); and
embedding at least one porous body (150) in the stack (101),
wherein the porous body (150) has an external surface (151) hindering a flow of material of the at least one electrically insulating layer structure (102) inside the porous body (150).

15. The method according to claim 14, further comprising:
coating the external surface (151) with a protection layer (110); and/or
changing the external surface (151) by a deformation; and/or
pressing the porous body (150), in particular when embedded in the stack (101).
